Europäisches Patentamt

European Patent Office

Office européen des brevets

(19)

(11) Publication number: **0 155 215**
**B1**

(12) # EUROPEAN PATENT SPECIFICATION

(45) Date of publication of patent specification: 20.07.88

(51) Int. Cl.⁴: **H 01 L 29/80,** H 01 L 29/36

(21) Application number: **85400448.8**

(22) Date of filing: **08.03.85**

(54) **High electron mobility semiconductor device employing selectively doped heterojunction.**

(30) Priority: **08.03.84 JP 44501/84**

(43) Date of publication of application:
**18.09.85 Bulletin 85/38**

(45) Publication of the grant of the patent:
**20.07.88 Bulletin 88/29**

(84) Designated Contracting States:
**DE FR GB IT**

(56) References cited:
**EP-A-0 045 181**

**JAPANESE JOURNAL OF APPLIED PHYSICS,
vol. 20, no. 4, April 1981, pages L245-L248,
Tokyo, JP; S. HIYAMIZU et al.: "Extremely high
mobility of two-dimensional electron gas in
selectively doped GaAs/N-AlGaAs
heterojunction structures grown by MBE"**

(73) Proprietor: **FUJITSU LIMITED**
**1015, Kamikodanaka Nakahara-ku
Kawasaki-shi Kanagawa 211 (JP)**

(72) Inventor: **Inata, Tsuguo**
**745, Itado
Isehara-shi Kanagawa, 259-11 (JP)**
Inventor: **Sasa, Shigehiko**
**2-12, Sakuradai 3 chome
Isehara-shi Kanagawa, 259-11 (JP)**

(74) Representative: **Descourtieux, Philippe et al
CABINET BEAU de LOMENIE 55 rue
d'Amsterdam
F-75008 Paris (FR)**

(56) References cited:
**APPLIED PHYSICS LETTERS, vol. 41, no. 6,
September 1982, pages 563-565, American
Institute of Physics, New York, US; W. KOPP et
al.: "Use of GaAs smoothing layer to improve
the heterointerface of GaAs/AlxGa1-xAs field-
effect transistors"**

Courier Press, Leamington Spa, England.

**0 155 215**

(56) References cited:
PATENTS ABSTRACTS OF JAPAN, vol. 7, no.
214 (E-199) 1359r, 21st September 1983; & JP -
A - 58 107 679 (MITSUBISHI DENKI K.K.)
27-06-1983

APPLIED PHYSICS LETTERS, vol. 40, no. 10,
May 1982, pages 879-881, American Institute of
Physics, New York, US; T.J. DRUMMOND et
al.: "Influence of AlxGa1-xAs buffer layers on
the performance of modulation-doped field-
effect transistors"

JAPANESE JOURNAL OF APPLIED PHYSICS,
vol. 21, no. 4, part 2, April 1982, pages
L223-L224, Tokyo, JP; R.E. THORNE et al.:
"Performance of inverted structure modulation
doped Schottky barrier field effect transistors"

### Description

#### Technical field

This invention relates to a semiconductor device with enhanced mobility employing a selectively doped heterojunction, and especially, to a structure of a semiconductor device which enables a high temperature treatment without disturbing the electron mobility of the two-dimensional electron gas, in order to install the device in an integrated circuit (IC).

#### Prior art

The following references are representative of the prior art in the area of high electron mobility semiconductor devices:

U.S. Patent No. 3,626,257 of Esaki et al. discloses various kinds of superlattice structures made by modulating the bandgap or doping so that the multilayered structures exhibit a negative resistance;

U.S. Patent No. 4,163,237 of Dingle et al. discloses the provision of buffer zones substantially free from impurities adjacent the heterojunctions, in order to further reduce impurity scattering; and

Japanese laid open patent applications Nos. 57-193067, 58-51573, 58-51574 and 58-51575 suggest improvements to impurity scattering and heat treatment.

#### Background of the invention

Silicon semiconductor devices are now playing the leading part for electronic equipments. But, on the other hand, new materials are looked for to further improve the operation speed of the devices. Gallium arsenide (GaAs) is one of such new materials which has a capability to obtain a higher operating speed because of its electron mobility higher than that of silicon, and devices using such a material are now under development.

As a device utilizing compound semi-conductor material such as gallium arsenide, the field effect transistor (FET) is ahead of development because its fabrication process is simple compared to that of a bipolar transistor. In particular, the Schottky barrier type FET whose parasitic capacitance is reduced by using a semi-insulating substrate of compound semiconductor is becoming a main stream of the development.

In normally structured semiconductor devices of silicon or gallium arsenide, carriers move through semiconductor lattice space where impurity ions are existing. The carrier have their motion affected by the lattice and the impurity ions, and lose their mobility by collision and scattering therewith. It is possible to decrease the effect of scattering by lattice (interaction with phonon) by decreasing the temperature, but it increases the scattering by impurity ions so that the mobility of the carriers is limited.

In order to sustain a high electron mobility, especially at cryogenic temperatures, by eliminating the effect of ionized impurity scattering, a multilayered structure has been proposed (for example U.S. Pat. 3,626,257 by Esaki et al.), with interleaving layers having different bandgap each other. The object of such a structure is to separate the layer where the carriers drift (known as channel layer) from the layer where impurity is doped to supply the carriers. Such a separation is obtained by heterojunction between the layers, so that this structure is known as selectively doped (or modulation doped) heterojunction FET, or high electron mobility transistor (HEMT).

In order to make clear the advantages of the present invention, the structure of prior art heterojunction FET, the problems raised, and some attempts to solve these problems will be described briefly.

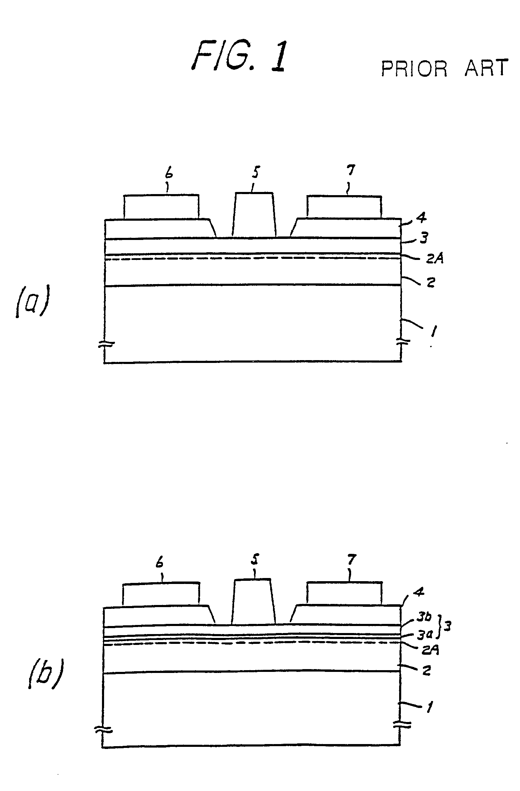

Fig. 1(a) and Fig. 1(b) show two types of prior art heterojunction FETs including a semi-insulating gallium arsenide (GaAs) substrate 1 which, in some cases, is intentionally doped with chromium (Cr) or iron (Fe) etc. to compensate the effect of unintentionally doped impurities, and provide a very high resistivity. On the substrate 1 are piled, in order from the surface of the substrate, an undoped i-type GaAs layer 2, an aluminum-gallium arsenide ($Al_xGa_{1-x}As$) layer 3 having an electron affinity smaller than that of the layer 2, and an n-type GaAs layer 4. The n-type GaAs layer 4 is highly doped to secure a good contact with contact wires and is shaped to form source and drain electrodes as shown in Figs. 1(a) and 1(b). When a gate electrode 5, a source electrode 6 and a drain electrode 7 are fabricated, the heterojunction FET is completed.

In the example of Fig. 1(a), the $Al_xGa_{1-x}As$ layer 3 is doped with silicon (Si), for example, and is of the n-type. Carriers (in this case electrons) formed in the doped layer 3 are transferred to the undoped layer 2 and accumulate in the layer 2 near the heterojunction between the i-type GaAs layer 2 and the $Al_xGa_{1-x}As$ layer 3, and form a two-dimensional electron gas 2A as shown in the figure. This two-dimensional electron gas (abbreviated as 2DEG) plays the role of a channel in the FET, and is often designated as channel layer. When the device is cooled to a cryogenic temperature, the lattice scattering decreases, and since the i-type GaAs layer 2 is not doped and has very rare ionized impurities, the 2DEG is not affected by the scattering by the ions and sustains a high mobility. Thus, a high speed operation of the heterojunction FET is attained.

It has been found that in the structure of Fig. 1(a) some of the carriers in the 2DEG 2A are affected by the ions in the $Al_xGa_{1-x}As$ layer 3, so that the mobility of the carriers may not be sufficiently high. It has then been proposed to provide a buffer zone or spacer between the 2DEG and the carrier supplying layer (reference can be made for example to U.S. Pat. 4,163,237). Fig. 1(b) shows an example of such a structure. Compared to Fig. 1(a), the $Al_xGa_{1-x}As$ layer 3 is subdivided into two layers 3a and 3b. Contiguous to the i-type GaAs layer 2 is formed a thin layer 3a of undoped $Al_xGa_{1-x}As$ which acts as buffer zone or spacer. Over the buffer zone 3a is formed the carrier supplying layer 3b which is a Si doped layer for example. The thickness of the buffer zone is a few tens of Å (between $10^{-9}$ and $10^{-8}$ m).

When using such a structure for GaAs devices, the 2DEG shows a mobility of $1 \times 10^5$ cm$^2$/V · s at 77°K, with a 2DEG concentration of $6 \times 10^{11}$ cm$^{-2}$ and the high speed operation of GaAs FETs has been improved to a great extent. But there came out another problem. The GaAs FETs having the above mentioned structure have been fabricated with a processing temperature fairly low compared to that of ordinary semiconductor or manufacturing process. For example, the source or drain electrode has been fabricated with an eutectic alloy of gold and gold-germanium (AuGe/Au) whose eutectic temperature is 450°C, and the heating time has been kept to less than one minute. With such care, the thermal diffusion of impurities from the doped $Al_xGa_{1-x}As$ layer 3b into the spacer region of undoped $Al_xGa_{1-x}As$ layer 3a has been suppressed. If not, the impurity in the layer 3b will diffuse into the spacer layer 3a, and cause the mobility to decrease by interaction with the impurity ions.

In this respect, it is to be noted that recent electron devices are used in complex form with some other devices. Therefore, a single FET is almost meaningless despite its very high speed; it must be used together with other devices, or be weaved into an IC or compose an IC by itself. In order to provide a practically usable high electron mobility transistor (HEMT), it is therefore necessary to make it able to withstand a process temperature of about 700°C. Such a temperature is required for example for driving impurities into a semiconductor material by diffusion, or for annealing the device to activate the impurities implanted by ion implantation.

To avoid this difficulty, one could think of applying a local heating by means of an energy beam such as an infrared ray or an electron beam, for example, but this is applicable only for limited cases. Some other attempts have been proposed, for example in the Japanese laid open patents Provisional Publication Nos. 57-193067, 58-51573, 58-51574 and 58-51575. One proposed attempt consists in providing a thick spacer layer estimating the diffusion of impurities into the spacer by thermal diffusion, and another one in providing additional n-GaAs layer. Though these attempts have their own significances, they are still insufficient to keep a high electron mobility while supporting a high process temperature.

It is therefore the main object of the present invention to provide a structure of high electron mobility semiconductor devices which can withstand a process temperature of more than 700°C.

Another object of the present invention is to provide a high electron mobility transistor (HEMT) which can be used together with other electron devices as an integrated circuit.

Summary of the invention

The inventors have noticed from experiments that the spacer layer of $Al_xGa_{1-x}As$ has an effect to prevent the interaction between the ionized impurities in the doped layer of $Al_xGa_{1-x}As$ (3b in Fig. 1(b), but has no ability to prevent the diffusion of impurity ions from the layer 3b into the layer 3a (spacer). Moreover if the substrate is heated, the Si impurity is distributed uniformly in both $Al_xGa_{1-x}As$ layers 3a and 3b. As a result, the effect of the spacer is lost. On the contrary, the layer of undoped GaAs layer (i-GaAs) has shown an effect to stop the diffusion of Si.

Based on the above discovery, the inventors have provided a second spacer consisting in an undoped GaAs (i-GaAs) layer over the prior art spacer formed of an undoped $Al_xGa_{1-x}As$ (i-$Al_xGa_{1-x}As$) layer, the carrier supplying layer of Si doped n-$Al_xGa_{1-x}As$ being fabricated over the second spacer.

The thickness of the second spacer (i-GaAs layer) is preferably comprised between 15 and 30 Å ($1.5 \times 10^{-9}$ and $3 \times 10^{-9}$ m), for example approximately 20 Å ($2 \times 10^{-9}$ m), whereas the first spacer (i-$Al_xGa_{1-x}As$ layer) has a thickness preferably comprised between 20 and 40 Å ($2 \times 10^{-9}$ and $4 \times 10^{-9}$ m), for example approximately 40 Å ($4 \times 10^{-9}$ m).

By applying such a configuration to a HEMT, it has become possible to treat the substrate up to 750°C for 20 minutes without resulting in a decrease of the mobility of the 2DEG. It has thus become possible to include a HEMT in an IC altogether with other electron devices.

Brief description of the drawings

Fig. 1 shows the fundamental structure of a multi-layered heterojunction device of the prior art, wherein:

(a) illustrates schematically a cross-sectional view of a multi-layered heterojunction FET; and

(b) illustrates a structure further comprising a spacer layer.

Fig. 2 shows how the carrier mobility and carrier concentration of prior art heterojunction FET varies with thermal treatment (conventional furnace annealing).

Fig. 3 is a graph showing that the mobility is decreased even by a thermal treatment of short duration, only 10 seconds (tungsten-halogen lamp treatment).

Fig. 4 shows the redistribution of Si in GaAs and $Al_xGa_{1-x}As$ by thermal treatment, wherein:

(a) shows the redistribution of Si in an $Al_xGa_{1-x}As$ layer; and

(b) shows the redistribution of Si in a GaAs layer.

Fig. 5 is a graph illustrating the effect of a GaAs layer to stop diffusion of Si impurities.

Fig. 6 is an example of a computer simulated profile showing the energy level and concentration of a two dimensional electron gas in a structure of a HEMT (high electron mobility transistor) according to the present invention.

Fig. 7 shows schematically a cross-sectional view of an embodiment of a HEMT according to the present invention.

Fig. 8 is a graph showing that the mobility of the 2DEG in a multilayered device according to the present invention is not decreased by thermal treatment.

Detailed description of the invention

As mentioned before when investigating the variation of mobility as a function of the thermal treatment of the substrate, the inventors have noticed that the undoped $Al_xGa_{1-x}As$ layer has no effect to prevent the diffusion of Si.

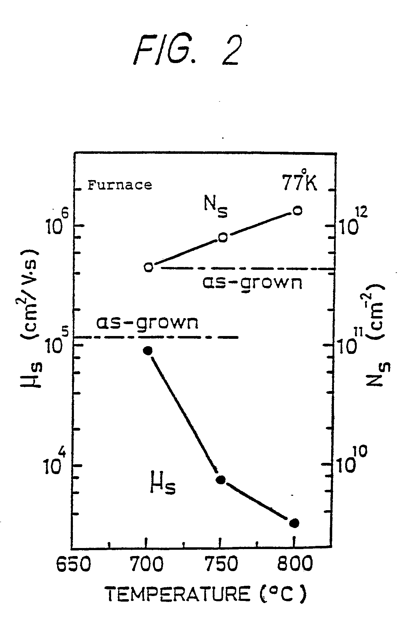

At first the variation of carrier mobility $\mu_s$ and carrier concentration $N_s$ of the 2DEG (two dimensional electron gas) have been measured at various temperatures. A substrate having the structure of Fig. 1(b) has been treated in a conventional electric furnace for 20 minutes and $\mu_s$ and $N_s$ have been measured at 77°K. In Fig. 2, the abscissa shows the temperature and the ordinate shows $\mu_s$ or $N_s$. As can be seen in this figure, the mobility decreases and the advantage of the multilayered heterojunction device is lost as the treatment temperature is raised.

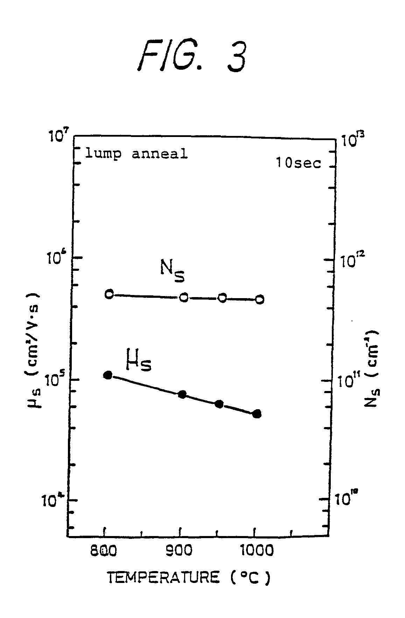

In an attempt to avoid the heating effect, the heating time has been reduced. For this purpose, a substrate having the same structure as in the above case has been annealed by means of a tungsten-halogen lamp heater for 10 seconds, and $\mu_s$ and $N_s$ have been measured at 77°K. Reducing the heating time is an effective method often used to avoid the defects of heating. However, as shown in Fig. 3, the mobility decreases even with a short time treatment of 10 seconds.

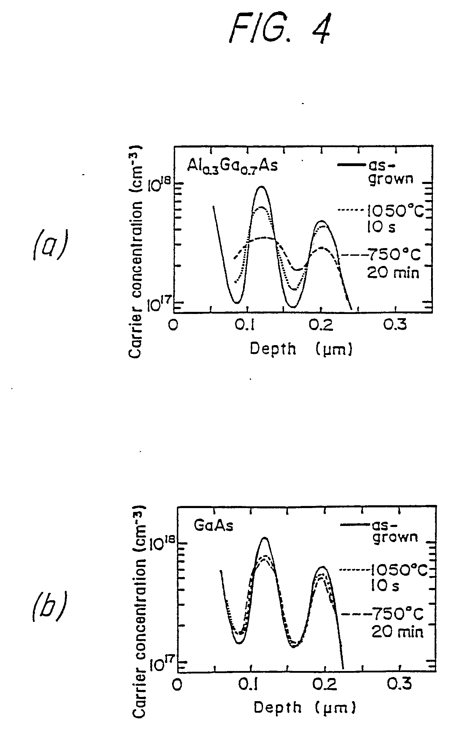

This is considered to be due to the diffusion of Si into the spacer. Therefore, the diffusion of Si in aluminium gallium arsenide has been investigated. For this purpose, a layer of $Al_{0.3}Ga_{0.7}As$ has been grown on a high resistivity GaAs substrate by molecular beam epitaxy. During the growth, the doping rate at various depth has been intentionally varied (such doping is sometimes called modulated doping) as shown in Fig. 4(a). In this figure, the abscissa is the distance from the surface of the grown layer toward the substrate, and the ordinate is the carrier concentration measured by capacitance-voltage (C—V) method. The heavy line indicates the concentration of the layer as grown. The substrate has been thermally processed by means of tungsten-halogen lamps (1050°C, 10 s) and by means of a conventional furnace (750°C 20 min). The dotted curve and the broken line respectively show the concentration after the above treatments. The curves show that Si is easily redistributed in the $Al_{0.3}Ga_{0.7}As$ layer by thermal diffusion. This indicates that the spacer layer is easily penetrated by Si impurity when it is thermally treated.

Similar investigations have been carried on with GaAs layers. In this case the GaAs layer has been grown on a high resistivity GaAs substrate by molecular beam epitaxy, and the doping has been varied as in the above case, i.e. as shown by the heavy line of Fig. 4(a). Measurement of carrier concentration has been made under the same conditions as precedingly. As can be seen from Fig. 4(b) the GaAs layer shows far less redistribution of Si in it compared to $Al_xGa_{1-x}As$. This indicates the possibility of forming a spacer with an undoped GaAs layer (i-GaAs layer).

At first it is considered to replace the $Al_xGa_{1-x}As$ spacer by a i-GaAs spacer. But it will be clear that such structure shows no difference compared to the structure of Fig. 1(a), and the spacer itself becomes a channel layer, so that the spacer effect is lost.

The results of a computer simulation of energy band diagram and carrier concentration of a 2DEG have shown a possibility to use the i-GaAs as impurity stopper, and it should be placed between the $Al_xGa_{1-x}As$ spacer and the n-$Al_xGa_{1-x}As$ carrier supplying layer.

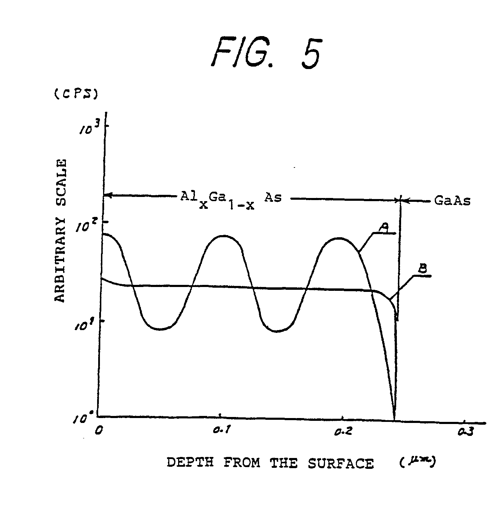

The effect of stopping impurity diffusion by the second spacer of the present invention is clearly apparent from the following experiment. On a GaAs substrate an undoped $Al_xGa_{1-x}As$ layer having a thickness of 5,000 Å (0.5 µm) and an $Al_xGa_{1-x}As$ layer having a thickness of 2,500 Å (0.25 µm) have been grown by molecular beam epitaxy, and the latter $Al_xGa_{1-x}As$ layer has been modulation doped as shown by curve A in Fig. 5. In this figure, the abscissa is the distance from the surface of the $Al_xGa_{1-x}As$ layer toward the substrate, and the ordinate is an arbitrary scale proportional to the impurity concentration. The substrate thus prepared has been cut into two parts; the impurity distribution of the $Al_xGa_{1-x}As$ layer as grown has been measured on one part (curve A); the other part has been thermally treated at 750°C for 80 minutes in a furnace, then the impurity distribution has been measured (curve B). In both cases, the impurity (Si) concentration has been measured by secondary ion mass spectroscopy (SIMS).

As can be seen in Fig. 5, the Si impurity in the $Al_xGa_{1-x}As$ layer is redistributed by the thermal treatment, but the diffusion of Si is stopped at the boundary with the GaAs layer and the concentration of Si decreases sharply (curve B). Therefore, i-GaAs appears to be very effective as a spacer for stopping the impurity diffusion.

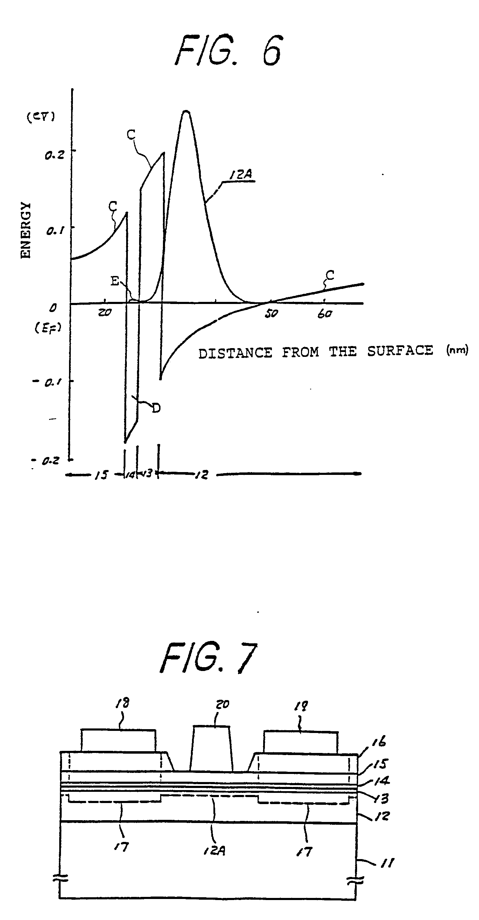

A practical multilayered structure according to the present invention has been determined from a computer aided simulation of energy band diagram and carrier concentration as shown in Fig. 6 by way of example.

Based on the above investigations and considerations the inventors have proposed an embodiment of a HEMT (high electron mobility transistor) according to the invention, as shown in Fig. 7. On a semi-insulating GaAs substrate 11, the following layers are fabricated one after the other for example by molecular beam epitaxial growth:

an undoped i-GaAs layer 12 having a thickness of 0.5 µm, for example, the upper part of which forms a channel layer 12A;

the first spacer layer 13 made from an undoped i-$Al_xGa_{1-x}As$ layer having a thickness of approximately 40 Å ($4 \times 10^{-9}$ m), whose aluminum composition x is 0.3 for example;

the second spacer layer 14 made from an undoped i-GaAs having a thickness of 20 Å ($2\times10^{-9}$ m), for example;

an n-type $Al_xGa_{1-x}As$ layer 15 having a thickness of approximately 600 Å ($60\times10^{-9}$ m), whose aluminum composition x is 0.3 for example, and doped with Si with a dose of approximately $1\times10^{18}$ cm$^{-3}$, this n-type $Al_xGa_{1-x}As$ layer 15 supplying the carriers to the channel layer 12A; and

an n-type GaAs layer 16 having a thickness of approximately 500 Å ($50\times10^{-9}$ m) and doped with silicon with a dose of $2\times10^{18}$ cm$^{-3}$, for example, the doped layer 16 providing a good ohmic contact with contact wires.

Into the source and drain regions 17 of the such prepared substrate impurity is implanted with a high dose to such a depth as to reach the i-GaAs layer 12. For example, selenium (Se) is ion implanted with energy of 350 Kev and with a dose of $1\times10^{14}$ cm$^{-2}$ at 200°C, and is then annealed at 950°C for 10 seconds using a tungsten-halogen lamp means. By this annealing n$^+$ regions 17 having a carrier concentration of approximately 4—$5\times10^{18}$ cm$^{-3}$ are formed.

Then by a conventional method, the source electrode 18 and drain electrode 19 are fabricated. A recess is made in the n-GaAs layer to expose the layer 15 for contacting a gate electrode 20 thereto.

Fig. 6 shows the energy band diagram and space distribution of the 2DEG near the channel region. In this figure, the abscissa is the distance from the surface of the n-$Al_xGa_{1-x}As$ layer 15, and the ordinate is the energy level. The curve C shows the energy level at each level of the cross-section of Fig. 7 and the curve 12A shows the concentration of the 2DEG with an arbitrary scale. These curves are obtained by computer simulation. When the width of the spacers 14 and 13 are varied, the 2DEG concentration varies. The curves of Fig. 6 correspond to the embodiment described with respect to Fig. 7, namely the widths of the first spacer 13 and of the second spacer 14 are being equal to 40 Å ($4\times10^{-9}$ m) and 20 Å ($2\times10^{-9}$ m), respectively, which is considered to be favourable.

The total width of the two spacers should be less than 100 Å ($10\times10^{-9}$ m) and preferably below approximately 60 Å ($6\times10^{-9}$ m) or less. If the total width is increased, the 2DEG concentration decreases, so that the g$_m$ of the FET will decrease. On the contrary when the width of the spacers is too much decreased, the concentration of the 2DEG in the spacer layer 13 will increase causing the scattering by the impurity ions in the layer 15 also to increase, and the mobility decreases. For this reason, it is desirable that the spacer layer 13 has a thickness larger than approximately 20 Å ($2\times10^{-9}$ m). The thickness of the second spacer layer 14 should be as small as possible. But, if it is too much decreased, the diffusion of impurity occurs. A thickness of approximately 15 Å ($1.5\times10^{-9}$ m) is preferred. The dimensions of the structure of Fig. 7 has been thus determined.

Generally speaking, the potential well D in Fig. 6 formed by the second spacer layer 14 has a capacity to capture and accumulate carriers in it, but since its width is very thin, the number of carriers (E in Fig. 6) captured by the potential well D is not so high. However, if the width of the second spacer layer 14 is increased, the charge captured in the potential well increases and causes an increase of impurity ion scattering, and the mobility is decreased. Therefore, the thickness of the second spacer 14 layer is preferably less than approximately 30 Å ($3\times10^{-9}$ m).

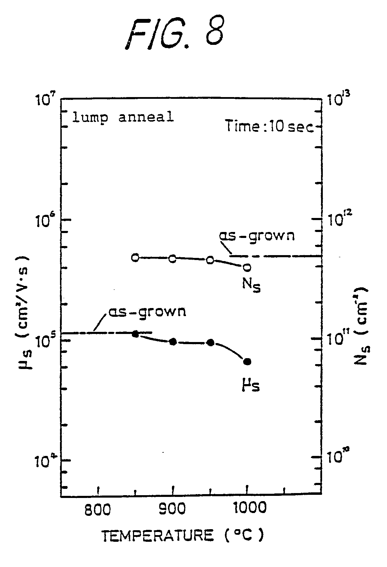

A substrate having the structure of Fig. 7 has been thermally treated during its fabrication process including a treatment at 750°C for 10 minutes and lamp annealing at 950°C. It has been further thermally treated for test with a tungsten-halogen lamp for 10 seconds at various temperatures, and the mobility and carrier concentration has been measured. Fig. 8 shows the results obtained. Compared to the curves of Fig. 3, the mobility does not decrease at 900°C, and keeps approximately its high value up to nearly 1,000°C.

This indicates that the structure of the present invention improves the durability of the multilayered heterojunction device at high temperatures, compared to the structures of the prior art, and keeps its high electron mobility. Therefore, the structure of the present invention is applicable to the making of ICs comprising high electron mobility transistors (HEMT).

The above disclosure has been made with respect to an n-channel FET, because the electron mobility is higher than that of the holes, this giving an advantage to n-channel devices over p-channel devices for high speed devices. But it will be clear for anyone skilled in the art that the invention can be easily extended to p-channel devices. Moreover, the heterojunction which accumulates the 2DEG (channel layer) is not limited to be formed by only one layer; a multilayered channel with an interleaving of a plurality of heterojunction layers can also be used.

**Claims**

1. High electron mobility semiconductor device comprising:

a channel layer (12) made from undoped gallium arsenide (i-GaAs);

a first spacer layer (13) made from undoped aluminum gallium arsenide (i-$Al_xGa_{1-x}As$) fabricated contiguous to said channel layer and forming an heterojunction therewith; and

an n-type aluminum gallium arsenide (n-$Al_xGa_{1-x}As$) layer (15);

said device being characterized in that it further comprises:

a second spacer layer (14) made from undoped gallium arsenide (i-GaAs) and located between said first spacer layer (13) and said n-$Al_xGa_{1-x}As$ layer (15) and contiguous thereto,

said second spacer layer (14) having a thickness to prevent the diffusion of impurity from said n-type aluminum gallium arsenide layer (15) to said channel layer (12), and the total thickness of said first and second spacers (13, 14) being such as to accumulate a two dimensional electron gas (2DEG) in said channel layer (12) close to said heterojunction.

2. A high electron mobility semiconductor device according to claim 1, characterized in that it comprises a substrate (11) made of high resistivity gallium arsenide, on which said channel layer (12) is fabricated contiguous to the substrate.

3. A high electron mobility semiconductor device according to any one of claims 1 or 2, characterized in that said total thickness of said first and second spacer layers (13, 14) is less than 10 nm.

4. A high electron mobility semiconductor device according to any one of claims 1 to 3, characterized in that the thickness of said second spacer layer (14) is comprised between substantially 1.5 and 3 nm.

5. A high electron mobility semiconductor device according to any one of claims 1 to 4, characterized in that the thickness of said first spacer layer (13) is comprised between substantially 2 and 4 nm.

6. A high electron mobility semiconductor device according to any one of claims 1 to 5, characterized in that the aluminum composition x in the first $Al_xGa_{1-x}As$ spacer layer (13) is substantially 0.3.

7. A high electron mobility semiconductor device according to any one of claims 1 to 6, characterized in that the aluminum composition x in the $n-Al_xGa_{1-x}As$ layer (15) is substantially 0.3.

8. A high electron mobility semiconductor device according to any one of claims 1 to 7, characterized in that said n-type $Al_xGa_{1-x}As$ layer (15) is doped with silicon.

9. A high electron mobility semiconductor device according to claim 8, characterized in that the dose of silicon is approximately $1 \times 10^{18}$ cm$^{-3}$.

10. A high electron mobility semiconductor device according to any one of claims 1 to 9, characterized in that the thickness of said channel layer (12) is approximately 0.5 μm.

11. A high electron mobility semiconductor device comprising:

a substrate (11) made of high resistivity GaAs;

a channel layer (12) made of undoped gallium arsenide (i-GaAs) layer of approximately 0.5 μm thick;

a first spacer layer (13) made from undoped aluminum gallium arsenide ($i-Al_xGa_{1-x}As$) having a thickness of approximately 4 nm and fabricated contiguous to said channel layer (12);

a second spacer layer (14) made from undoped gallium arsenide (i-GaAs) having a thickness of approximately 2 nm and fabricated contiguous to said first spacer layer (13);

a first n-type aluminum gallium arsenide ($n-Al_xGa_{1-x}As$) layer (15) having a thickness of approximately 60 nm fabricated contiguous to said second spacer layer (14);

a second n-type gallium arsenide (n-GaAs) layer (16) having a thickness of approximately 50 nm fabricated contiguous to said first n-type aluminum gallium arsenide ($n-Al_xGa_{1-x}As$) layer (15);

a recess fabricated in said second n-type gallium arsenide (n-GaAs) layer (16) to expose the first $n-Al_xGa_{1-x}As$ layer (15);

n-type regions (17) highly doped with selenium (Se) and reaching the channel layer (12) from the surface of the second n-GaAs layer (16);

a gate electrode (20) contacted to said first $n-Al_xGa_{1-x}As$ layer (15) in said recess; and

source and drain electrodes (18, 19) respectively connected to said highly doped n-type regions (17).

**Patentansprüche**

1. Halbleitervorrichtung hoher Elektronenmobilität mit:

einer Kanalschicht (12), die aus undotiertem Galliumarsenid (i-GaAs) hergestellt ist;

einer ersten Abstandsschicht (13), die aus undotiertem Aluminiumgalliumarsenid ($i-Al_xGa_{1-x}As$) hergestellt ist und an die genannte Kanalschicht angrenzt und einen Heteroübergang mit dieser bildet; und

einer Aluminiumgalliumarsenid ($n-Al_xGa_{1-x}As$)-Schicht (15) vom n-Typ;

welche genannte Vorrichtung dadurch gekennzeichnet ist, daß sie ferner umfaßt:

eine zweite Abstandsschicht (14), die aus undotiertem Galliumarsenid (i-GaAs) hergestellt ist und zwischen der genannten ersten Abstandsschicht (13) und der genannten $n-Al_xGa_{1-x}As$-Schicht (15) angeordnet und an diese angrenzend ist,

die genannte zweite Abstandsschicht (14) eine Dicke hat, um die Diffusion von Verunreinigung von der genannten Aluminiumgalliumarsenidschicht (15) vom n-Typ in die genannte Kanalschicht (12) zu verhindern, und die geamte Dicke der genannten ersten und zweiten Abstandsschichten (13, 14) so ist, daß ein zweidimensionales Elektronengas (2DEG) sich in der genannten Kanalschicht (12) nahe dem genannten Heteroübergang ansammelt.

2. Halbleitervorrichtung hoher Elektronenmobilität nach Anspruch 1, dadurch gekennzeichnet, daß sie ein Substrat (11) umfaßt, das aus Galliumarsenid hohen spezifischen Widerstands besteht, auf welchem die genannte Kanalschicht (12) an das Substrat angrenzend hergestellt ist.

3. Halbleitervorrichtung hoher Elektronenmobilität nach Anspruch 1 oder 2, dadurch gekennzeichnet, daß die gesamte Dicke der genannten ersten und zweiten Abstandsschichten (13, 14) geringer als 10 nm ist.

4. Halbleitervorrichtung hoher Elektronenmobilität nach einem der Ansprüche 1 bis 3, dadurch gekennzeichnet, daß die Dicke der genannten zweiten Abstandsschicht (14) zwischen im wesentlichen 1.5 und 3 nm beträgt.

5. Halbleitervorrichtung hoher Elektronenmobilität nach einem der Ansprüche 1 bis 4, dadurch gekennzeichnet, daß die Dicke der genannten ersten Abstandsschicht (13) zwischen im wesentlichen 2 und 4 nm beträgt.

6. Halbleitervorrichtung hoher Elektronenmobilität nach einem der Ansprüche 1 bis 5, dadurch gekennzeichnet, daß die Aluminiumzusammensetzung x in der ersten $Al_xGa_{1-x}As$-Abstandsschicht (13) im wesentlichen 0.3 beträgt.

7. Halbleitervorrichtung hoher Elektronenmobilität nach einem der Ansprüche 1 bis 6, dadurch gekennzeichnet, daß die Aluminiumzusammensetzung x in der n-$Al_xGa_{1-x}As$-Schicht (15) im wesentlichen 0.3 beträgt.

8. Halbleitervorrichtung hoher Elektronenmobilität nach einem der Ansprüche 1 bis 7, dadurch gekennzeichnet, daß die genannte n-Typ-$Al_xGa_{1-x}As$-Schicht (15) mit Silizium dotiert ist.

9. Halbleitervorrichtung hoher Elektronenmobilität nach Anspruch 8, dadurch gekennzeichnet, daß die Dosis von Silizium etwa $1 \times 10^{18}$ cm$^{-3}$ beträgt.

10. Halbleitervorrichtung hoher Elektronenmobilität nach einem der Ansprüche 1 bis 9, dadurch gekennzeichnet, daß die Dicke der genannten Kanalschicht (12) etwa 0.5 µm beträgt.

11. Halbleitervorrichtung hoher Elektronenmobilität mit:

einem Substrat (11), das aus GaAs hohen spezifischen Widerstands hergestellt ist;

einer Kanalschicht (12), die auf undotiertem Galliumarsenid (i-GaAs)-Schicht aus etwa 0.5 µm Dicke hergestellt ist;

einer ersten Abstandsschicht (13), hergestellt aus undotiertem Aluminiumgalliumarsenid (i-$Al_xGa_{1-x}As$), mit einer Dicke von etwa 4 nm und an die genannte Kanalschicht (12) angrenzend;

einer zweiten Abstandsschicht (14), die aus undotiertem Galliumarsenid (i-GaAs) hergestellt ist, welche eine Dicke von etwa 2 nm hat und an die genannte erste Abstandsschicht (13) angrenzend hergestellt ist;

einer ersten n-Typ-Aluminiumgalliumarsenid-(n-$Al_xGa_{1-x}As$)-Schicht (15), die eine Dicke von etwa 60 nm hat und an die zweite Abstandsschicht (14) angrenzend hergestellt ist;

einer zweiten n-Typ-Galliumarsenid (n-GaAs)-Schicht (16), die eine Dicke von etwa 50 nm hat und an die erste n-Typ-Aluminiumgalliumarsenid-(n-$Al_xGa_{1-x}As$)-Schicht (15) angrenzend hergestellt ist;

einer Ausnehmung, die in der zweiten Galliumarsenid-(n-GaAs)-Schicht (16) vom n-Typ hergestellt ist, um die erste n-$Al_xGa_{1-x}As$-Schicht (15) zu exponieren;

n-Typ-Bereichen (17), die mit Selen (Se) hoch dotiert sind und die Kanalschicht (12) von der Oberfläche der zweiten n-GaAs-Schicht (16) erreichen;

einer Gateelektrode (20), die mit der genannten ersten n-$Al_xGa_{1-x}As$-Schicht (15) in der genannten Ausnehmung kontaktiert; und

Source- und Drainelektroden (18, 19), die jeweils mit den genannten hochdotierten n-Typ-Bereichen (17) verbunden sind.

**Revendications**

1. Dispositif semiconducteur à haute mobilité électronique, comprenant:

une couche de canal (12) fait d'arséniure de gallium non dopé (GaAs de type i);

une première couche tampon (13) faite d'arséniure de gallium-aluminium non dopé ($Al_xGa_{1-x}As$ de type i) fabriquée en contiguïté avec ladite couche de canal et formant une hétérojonction avec celle-ci; et

une couche (15) d'arséniure de gallium-aluminium de type n ($Al_xGa_{1-x}As$ de type n);

ledit dispositif étant caractérisé en ce qu'il comprend en outre:

une deuxième couche tampon (14) faite d'arséniure de gallium non dopé (GaAs de type i) et placée entre ladite première couche tampon (13) et ladite couche (15) de $Al_xGa_{1-x}As$ de type n, en contiguïté avec celles-ci,

la deuxième couche tampon (14) possédant une épaisseur permettant d'empêcher la diffusion d'impuretés de ladite couche (15) d'arséniure de gallium-aluminium de type n dans ladite couche de canal (12), et l'épaisseur totale desdites première et deuxième couches tampons (13, 14) étant telle qu'il y a accumulation d'un gaz électronique bidimensionnel (2DEG) dans ladite couche de canal (12) au voisinage de ladite hétérojonction.

2. Dispositif semiconducteur à haute mobilité électronique selon la revendication 1, caractérisé en ce qu'il comprend un substrat (11) fait d'arséniure de gallium de haute résistivité, sur lequel ladite couche de canal (12) est fabriquée en contiguïté avec le substrat.

3. Dispositif semiconducteur à haute mobilité électronique selon l'une quelconque des revendications 1 et 2, caractérisé en ce que ladite épaisseur totale desdites première et deuxième couches tampons (13, 14) est inférieure à 10 nm.

4. Dispositif semiconducteur à haute mobilité électronique selon l'une quelconque des revendications 1 à 3, caractérisé en ce que l'épaisseur de ladite deuxième couche tampon (14) est comprise entre sensiblement 1,5 et 3 nm.

5. Dispositif semiconducteur à haute mobilité électronique selon l'une quelconque des revendications 1 à 4, caractérisé en ce que l'épaisseur de ladite première couche tampon (13) est comprise entre sensiblement 2 et 4 nm.

6. Dispositif semiconducteur à haute mobilité électronique selon l'une quelconque des revendications 1 à 5, caractérisé en ce que la composition x en aluminium de la première couche tampon (13) de $Al_xGa_{1-x}As$ est sensiblement 0,3.

7. Dispositif semiconducteur à haute mobilité électronique selon l'une quelconque des revendications 1 à 6, caractérisé en ce que la composition x en aluminium de la couche (15) de $Al_xGa_{1-x}As$ de type n est sensiblement 0,3.

8. Dispositif semiconducteur à haute mobilité électronique selon l'une quelconque des revendications 1 à 7, caractérisé en ce que ladite couche (15) de $Al_xGa_{1-x}As$ de type n est dopée à l'aide de silicium.

9. Dispositif semiconducteur à haute mobilité électronique selon la revendication 8, caractérisé en ce que la dose de silicium est environ $1 \times 10^{18}$ cm$^{-3}$.

10. Dispositif semiconducteur à haute mobilité électronique selon l'une quelconque des revendications 1 à 9, caractérisé en ce que l'épaisseur de ladite couche de canal (12) est environ 0,5 µm.

11. Dispositif semiconducteur à haute mobilité électronique, comprenant:

un substrat (11) fait de GaAs de résistivité élevée;

une couche de canal (12) faite d'une couche d'arséniure de gallium non dopé (GaAs de type $i$) d'une épaisseur d'environ 0,5 µm;

une première couche tampon (13) faite d'arséniure de gallium-aluminium non dopé (Al$_x$Ga$_{1-x}$As de type $i$) ayant une épaisseur d'environ 4 nm et fabriquée en contiguïté avec ladite couche de canal (12);

une deuxième couche tampon (14) faite d'arséniure de gallium non dopé (GaAs de type $i$) ayant une épaisseur d'environ 2 nm et fabriquée en contiguïté avec ladite première couche tampon (13);

une première couche (15) d'arséniure de gallium-aluminium de type n (Al$_x$Ga$_{1-x}$As de type n) possédant une épaisseur d'environ 60 nm et fabriquée en contiguïté avec ladite deuxième couche tampon (14);

une deuxième couche (16) d'arséniure de gallium de type n (GaAs de type n) possédant une épaisseur d'environ 50 nm et fabriquée en contiguïté avec ladite première couche (15) d'arséniure de gallium-aluminium de type n (Al$_x$Ga$_{1-x}$As de type n);

un évidement formé dans ladite deuxième couche (16) d'arséniure de gallium de type n (GaAs de type n) afin de mettre à découvert la première couche (15) de Al$_x$Ga$_{1-x}$As de type n;

des régions (17) de type n fortement dopées à l'aide de sélénium (Se) et atteignant la couche de canal (12) depuis la surface de la deuxième couche (16) de GaAs de type n;

une électrode de grille (20) mise en contact avec ladite première couche (15) de Al$_x$Ga$_{1-x}$As de type n dans ledit évidement; et

des électrodes de source et de drain (18, 19) respectivement connectées auxdites régions (17) de type n fortement dopées.

0 155 215

FIG. 1    PRIOR ART

(a)

(b)

1

# FIG. 2

# FIG. 3

# FIG. 4

(a)

(b)

FIG. 5

FIG. 6

FIG. 7

## FIG. 8